(19) Europäisches Patentamt
European Patent Office
Office européen des brevets

(11) EP 2 455 955 A2

(12) # EUROPEAN PATENT APPLICATION

(43) Date of publication:
**23.05.2012 Bulletin 2012/21**

(51) Int Cl.:
***H01G 9/20*** *(2006.01)*

(21) Application number: **11182215.1**

(22) Date of filing: **21.09.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **23.11.2010 KR 20100117096**

(71) Applicant: **SAMSUNG SDI CO., LTD.**
**Yongin-si, Gyeonggi-do (KR)**

(72) Inventors:
- **Kang, Moon-Sung**
**Gyeonggi-do (KR)**
- **Lee, Ji-Won**
**Gyeonggi-do (KR)**
- **Shin, Byong-Cheol**
**Gyeonggi-do (KR)**
- **Cha, Si-Young**
**Gyeonggi-do (KR)**
- **Kim, Myung-Seop**
**Gyeonggi-do (KR)**

(74) Representative: **Sampson, Eimear et al**
**Venner Shipley LLP**
**200 Aldersgate**
**London EC1A 4HD (GB)**

(54) **Gel electrolyte for dye sensitized solar cell and dye sensitized solar cell including the gel electrolyte**

(57) A gel electrolyte for a dye sensitized solar cell and a dye sensitized solar cell including the gel electrolyte. The gel electrolyte includes: a redox couple generated from a polymer-iodine complex and an iodide salt; inorganic nanoparticles; and a high-viscosity organic solvent.
The polymer-iodine complex is represented by Formula 1 below:

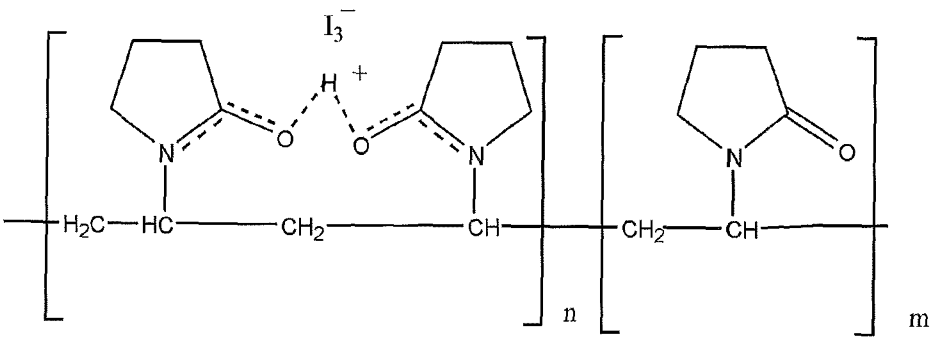

wherein n is a number from 5 to 1,000, and
m is a number from 5 to 10,000.

EP 2 455 955 A2

FIG. 1

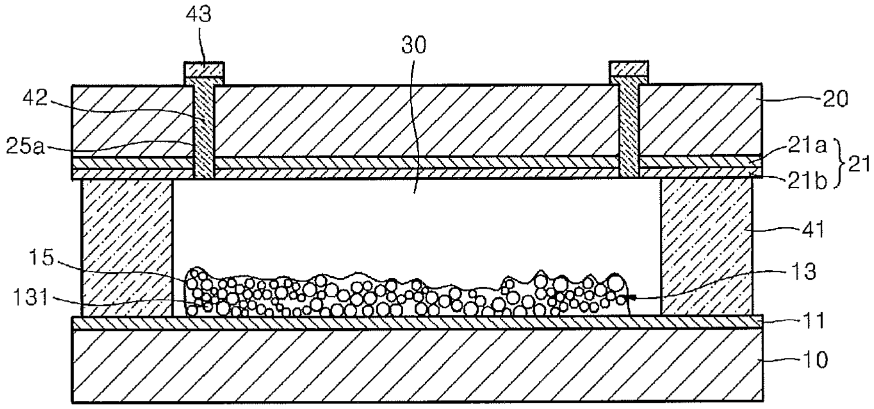

## Description

The present invention relates to a gel electrolyte for a dye sensitized solar cell and a dye sensitized solar cell including the gel electrolyte.

Dye sensitized solar cells are photoelectro-chemical solar cells using photosensitive dye molecules that absorb visible light to generate electron-hole pairs and an oxide semiconductor electrode formed of titanium oxide for delivering generated electrons. A photoelectro-chemical solar cell includes a photo-cathode including a semiconductor oxide nanoparticle layer to which dye molecules are adsorbed, an opposite electrode including a platinum catalyst, and an electrolyte including a redox ion couple.

From among the components of the photoelectro-chemical solar cell, the electrolyte is a key element in determining the photoelectric efficiency and durability of the solar cell.

Conventional dye sensitized solar cells include low-viscosity volatile organic solvents as liquid electrolytes. Liquid electrolytes have high ionic conductivity and thus, high photoelectric conversion efficiency. However, the liquid electrolytes may leak or evaporate, and thus, a solar cell including the liquid electrolyte may have low durability. Accordingly, to prevent leakage and evaporation, a solvent that has high viscosity and a high boiling point is needed.

However, when such a solvent is used in an electrode, the ionic conductivity of an electrolyte is low. Thus, there is a need to increase the number of ions. However, as the number of ions increases, iodine-induced photo absorption and a dark current occur, and thus, an open voltage is reduced and a metal electrode is corroded faster.

According to a first aspect of the present invention there is provided a gel electrolyte for a dye sensitized solar cell including a redox couple generated from a polymer-iodine complex and an iodide salt; inorganic nanoparticles; and a high-viscosity organic solvent. According to a second aspect of the present invention there is provided a dye sensitized solar cell including a first electrode; a light absorption layer formed on a surface of the first electrode; a second electrode facing the first electrode on which the light absorption layer is formed; and a gel electrolyte according to the invention in its first aspect interposed between the light absorption layer and the second electrode.

Further embodiments of the invention are as set out below or as defined in the sub-claims.

In an embodiment, the polymer-iodine complex is represented by Formula1 below:

Formula 1

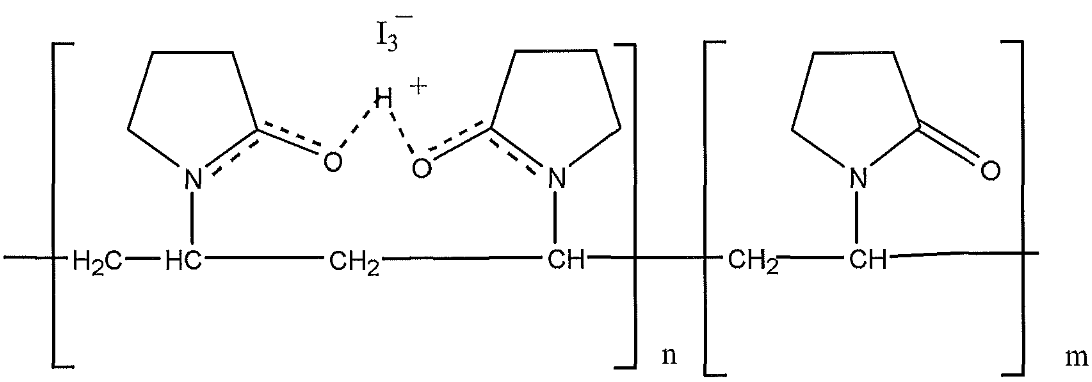

wherein n is a number from 5 to 1,000, and
m is a number from 5 to 10,000.

A gel electrolyte for a dye sensitized solar cell according to the invention may have high ionic conductivity and high stability.

A more complete appreciation of the present invention, and many of the attendant advantages thereof, will be readily apparent as the same becomes better understood by reference to the following detailed description when considered in conjunction with the accompanying drawings, wherein:

Figure 1 is a cross-sectional view of a dye sensitized solar cell according to an embodiment of the present invention;

Figures 2A and Figure 2B show cell impedance test results of a gel electrolyte prepared according to Example 1;

Figure 3 is a graph of photoelectron conversion efficiency of electrolytes prepared according to Example 1, Comparative Example 1, and Comparative Example 3 with respect to an iodine concentration;

Figure 4 is a graph of impedance of electrolytes prepared according to Example 1, Comparative Example 1, and

Comparative Example 3 with respect to an iodine concentration; and

Figure 5 is a graph of a grid resistance of electrolytes prepared according to Example 1 and Comparative Example 2 with respect to silver grid corrosion.

Reference will now be made in detail to embodiments, examples of which are illustrated in the accompanying drawings, wherein like reference numerals refer to the like elements throughout.

A gel electrolyte for a dye sensitized solar cell according to an aspect of the present invention includes a redox couple generated from a polymer-iodine complex and an iodide salt (e.g., the polymer-iodine Ω the iodide salt constituting the redox couple); inorganic nanoparticles; and a high-viscosity organic solvent.

The polymer included in the polymer-iodine complex may be any one of various suitable polymers that enable formation of a complex with iodine. Examples of such suitable polymers are polyvinylalcohol, polyvinylpyrrolidone, polyvinylpyridine, nylon, polysaccharide, or mixtures thereof.

An example of the polymer-iodine complex may be a polyvinylpyrrolidone-iodine complex represented by Formula 1 below:

**Formula 1**

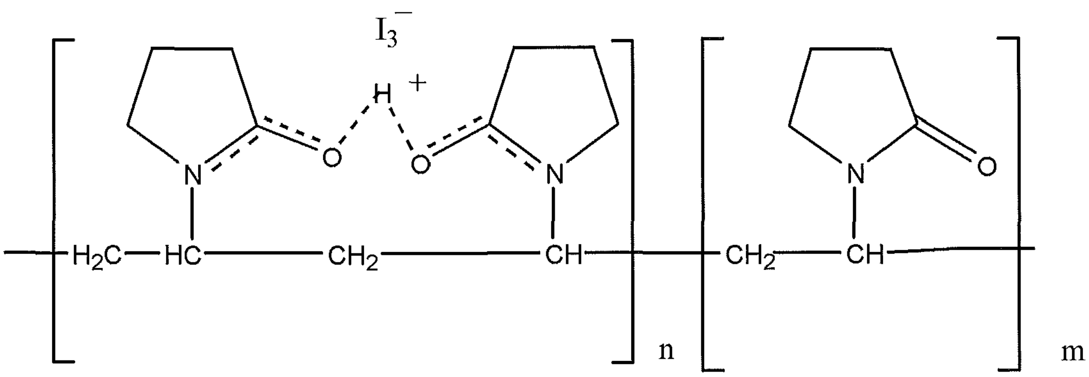

in which n is a number (e.g., an integer) from 5 to 1,000, and
m is a number from 5 to 10,000.

In the polymer-iodine complex illustrated in Formula 1, iodine is captured by the polymer and thus the iodine may not freely diffuse. Thus, metal electrode corrosion caused by iodine flowing through micropores formed in a protection layer may be substantially suppressed. Accordingly, compared to a comparable electrolyte including iodine, when the gel electrolyte is used, the corrosion of metal electrode may be substantially suppressed.

The polymer-iodine complex may be in an amount of between 40 and 400 parts by weight based on 100 parts by weight of the inorganic nanoparticles. If the amount of the polymer-iodine complex is within the range described above, redox performance of the gel electrolyte is high.

In the polymer-iodine complex, a mixed mole ratio of a repeating unit of the polymer to iodine may be in a range of 20:1 to 1:1, for example 10:1 to 5:1. If the mixed mole ratio of the repeating unit of the polymer to iodine is within the range described above, redox is smoothly performed.

The iodine contained in the polymer-iodine complex may be in of between 0.01 and 0.10 mol/L, for example, between 0.03 and 0.06 mol/L. If the amount of iodine is within the range described above, recombination of electrons is smoothly performed.

The iodide salt may include at least one selected from the group consisting of lithium iodide (LiI), bromine iodide (LiBr), sodium iodide, potassium iodine, magnesium iodide, copper iodide, silicon iodide, manganese iodide, barium iodide, molybdenum iodide, calcium iodide, iron iodide, caesium iodide, zinc iodide, mercury iodide, ammonium iodide, methyl iodide, methylene iodide, ethyl iodide, ethylene iodide, isopropyl iodide, isobutyl iodide, benzyl iodide, benzoyl iodide, allyl iodide, imidazolium iodide, pyridinium iodide, and pyrrolidinium iodide.

The redox couple generated from a polymer-iodine complex may include a cation of the polymer-iodine complex and an iodine ion ($I^-/I_3^-$).

The redox couple may be in an amount of between 40 and 400 parts by weight based on 100 parts by weight of the inorganic nanoparticles. If the redox couple is within the range described above, the gel electrolyte has high ionic conductivity.

Due to the inorganic nanoparticles, ions are aligned at surfaces of the inorganic nanoparticles and move fast due to an exchange mechanism even in a high-viscosity state, and thus, the ionic conductivity of the gel electrolyte is

improved and an optimal iodine concentration can be lowered. Accordingly, since inorganic nanoparticles are used together with the polymer-iodine complex in the gel electrolyte, high ionic conductivity of the gel electrolyte may be obtained even at a low iodine concentration.

The inorganic nanoparticles may be, for example, selected from the group consisting of titania, silica, and indium tin oxide.

The inorganic nanoparticles may have an average particle diameter of between 5 and 200 nm, for example, between 10 and 50 nm. If the average particle of the inorganic nanoparticles is within the range described above, the gel electrolyte has high ionic conductivity.

The inorganic nanoparticles are comprised in an amount of between 1 and 20 parts by weight, for example, between 5 and 10 parts by weight, based on 100 parts by weight of the total weight of the gel electrolyte. If the amount of the inorganic nanoparticles is within the range described above, the gel electrolyte has high ionic conductivity.

The gel electrolyte includes a high-viscosity organic solvent.

The high-viscosity organic solvent may be an organic solvent having a boiling point of 120°C or higher. In an embodiment, the high-viscosity organic solvent has a boiling point of 150°C or higher. For example, the high-viscosity organic solvent may include at least one selected from the group consisting of 3-methoxypropionnitrile, N-methylpyrrolidone (NMP), 1-alkyl (R)-3-methylimidazolium tetracyanoborate, 1-alkyl(R)-3-methylimidazolium dicyanamide, and 1-alkyl(R)-3-methylimidazolium-bis(trifluoromethylsulfonyl)imide. The alkyl(R) may be a C1-C20 alkyl or a C2-C20 alkenyl, and examples of the alkyl are methyl, ethyl, butyl, pentyl, hexyl, propyl, dimethyl, allyl, etc.

Examples of a high-viscosity organic solvent are 3-methoxypropionitrile, 1-ethyl-3-methylimidazolium tetracyanoborate, 1-ethyl-3-methylimidazolium bis(trifluoromethylsulfonyl)imide, 1-ethyl-3-methylimidazolium dicyanoamide, 1-ethyl-3-methylimidazolium trifluoromethanesulfonate, 1-ethyl-3-methylimidazolium methylsulfate, 1-ethyl-3-methylimidazolium tetrafluoroborate, and a mixture thereof.

The high-viscosity organic solvent may be comprised in an amount of between 1000 and 1600 parts by weight based on 100 parts by weight of the inorganic nanoparticles. If the amount of the high-viscosity organic solvent is within the range described above, the gel electrolyte has high ionic conductivity.

The gel electrolyte may further include a polymer for controlling viscosity of the gel electrolyte. The viscosity-controlling polymer may control viscosity of the gel electrolyte and may act as a solvent for dissolving the iodide salt.

The viscosity-controlling polymer may include at least one selected from the group consisting of an ethylene oxide-based polymer and a vinylidenefluoride-hexafluoropropylene copolymer.

The viscosity-controlling polymer may have a weight average molecular weight of between 5,000 and 1,000,000 g/mol, for example, between 100,000 and 500,000 g/mol, for example, at 300,000 g/mol. If the weight average molecular weight of the viscosity-controlling polymer is within the range described above, the gel electrolyte has an appropriate viscosity, and thus, has high ionic conductivity.

The viscosity-controlling polymer may be comprised in an amount of between 20 and 200 parts by weight based on 100 parts by weight of the inorganic nanoparticles. If the amount of the viscosity-controlling polymer is within the range described above, the gel electrolyte has an appropriate viscosity, and thus, has high ionic conductivity.

The gel electrolyte may further include a nitrogen-containing additive for improving current and voltage characteristics of a solar cell. The nitrogen-containing additive may be included in an amount of between 100 and 300 parts by weight based on 100 parts by weight of the inorganic nanoparticles.

Examples of a nitrogen-containing additive are 4-tert-butylpyridine, pyrazole, imidazole, 1,2,3-triazole, 1,2,4-triazole, tetrazole, pyridines, pyridazine, pyrimidine, pyrazine, 1,3,5-triazine, 2-aminoquinoline, 3-aminoquinoline, 5-aininoquinoline, or 6-aminoquinoline.

Since the amount of iodine included in the gel electrolyte is reduced or minimized, the gel electrolyte is efficient and stable and also has high ionic conductivity.

Figure 1 is a cross-sectional view of a dye sensitized solar cell according to an embodiment of the present invention.

Referring to Figure 1, the dye sensitized solar cell according to an embodiment of the present invention includes a first substrate 10, a first electrode 11, a light absorption layer 13, a dye 15, a second electrode 21, a second substrate 20 facing the first substrate 10, and an electrolyte 30 interposed between the first electrode 11 and the second electrode 21, wherein the first electrode 11, the light absorption layer 13, and the dye 15 are formed on the first substrate 10 and the second electrode 21 is formed on the second substrate 20. A separate case may be further disposed outside the first substrate 10 and the second substrate 20. The structure described above will now be described in more detail.

The first substrate 10 acts as a support for the first electrode 11 in the present embodiment and may be transparent, thereby allowing passage of external light. The first substrate 10 may be formed of glass or plastic. Examples of plastic for forming the first substrate 10 are polyethylene terephthalate (PET), polyethylene naphthalate (PEN), polycarbonate (PC), polypropylene (PP), polyimide poly imide (PI), or triacetyl cellulose (TAC).

The first electrode 11 formed on the first substrate 10 may be formed of a transparent material including at least one selected from the group consisting of indium tin oxide, indium oxide, tin oxide, zinc oxide, sulfur oxide, fluorine

oxide, $ZnO-Ga_2O_3$, and $ZnO-Al_2O_3$. The first electrode 11 may be a mono layer or a stacked layer of the transparent materials described above.

The light absorption layer 13 is formed on the first electrode 11. The light absorption layer 13 includes titanium dioxide particles 131 and pores with an appropriate average pore size. Due to the pores, the electrolyte 30 may smoothly flow and necking characteristics of the titanium dioxide particles 131 may be improved.

The light absorption layer 13 may have a thickness of between 10 nm and 3000 nm, for example, between 10 nm and 1000 nm. However, the thickness of the light absorption layer 13 is not limited thereto and may be changed according to the future technology development.

The dye 15 may be adsorbed to a surface of the light absorption layer 13 and may absorb external light to generate excited electrons.

Also, the second substrate 20 facing the first substrate 10 may act as a support for the second electrode 21, and may be transparent. Like the first substrate 10, the second substrate 20 may be formed of glass or plastic.

The second electrode 21 formed on the second substrate 20 is disposed to face the first electrode 11 and may include a transparent electrode 21a and a catalyst electrode 21b.

The transparent electrode 21a may be formed of a transparent material such as indium tin oxide, fluorine tin oxide, antimony tin oxide, zinc oxide, tin oxide, $ZnO-Ga_2O_3$, or $ZnO-Al_2O_3$. The transparent electrode 21a may be a mono layer or a stacked layer of the transparent materials described above.

The catalyst electrode 21b may activate the redox couple and may be a platinum electrode.

The first substrate 10 is combined with the second substrate 20 using an adhesive 41, and the electrolyte 30 is injected through holes 25a passing through the second substrate 20 and the second electrode 21 to fill a space between the first electrode 11 and the second electrode 21. The electrolyte 30 may uniformly diffuse into the light absorption layer 13. The electrolyte 30 receives electrons (generated by oxidation and reduction) from the second electrode 21 and delivers the electrons to the dye 15. The holes 25a passing through the second substrate 20 and the second electrode 21 are sealed by the adhesive 42 and the cover glass 43.

Although not illustrated in Figure 1, a typical porous metal oxide layer may be further formed between the first electrode 11 and the light absorption layer 13. In this regard, the light absorption layer 13 acts as a light scattering electrode and allows a large amount of dye to be adsorbed thereto. Due to such characteristics of the light absorption layer 13, disadvantages of conventional light scattering electrodes may be overcome. Thus, the dye sensitized solar cell including the light absorption layer 13 has relatively high efficiency.

The typical porous metal oxide layer may be formed of metal oxide particles, such as titanium dioxide, zinc oxide, tin oxide, strontium oxide, indium oxide, iridium oxide, lanthanum oxide, vanadium oxide, molybdenum oxide, tungsten oxide, niobium oxide, magnesium oxide, aluminium oxide, yttrium oxide, scandium oxide, samarium oxide, gallium oxide, or strontium titanium oxide. In this regard, an example of the metal oxide particles may be $TiO_2$ as titanium dioxide, $SnO_2$ as tin oxide, $WO_3$ as tungsten oxide, ZnO as zinc oxide, or a combination thereof.

Hereinafter, a method of manufacturing a dye sensitized solar cell according to an embodiment of the present invention will be described in more detail.

First, a light absorption layer including a porous film to which dye is adsorbed is formed on a first electrode.

Separately, a second electrode, configured to include a photo-cathode and to have holes (e.g., holes 25a), is prepared; and the second electrode is combined with the first electrode on which the light absorption layer is formed.

An electrolyte forming composition is injected through the holes of the second electrode, thereby completing the manufacturing of the dye sensitized solar cell.

The electrolyte forming composition includes a polymer-iodine complex, an iodide salt, a high-boiling point solvent, and inorganic nanoparticles. The electrolyte forming composition may further include at least one selected from the group consisting of a viscosity-controlling polymer and a nitrogen-containing additive.

A method of manufacturing a dye sensitized solar cell according to an embodiment of the present invention will now be described in more detail.

First, a light absorption layer including a porous film to which dye is adsorbed is formed on a first electrode.

Separately, a polymer-iodine complex, iodide salt, a high-boiling point solvent, and inorganic nanoparticles are mixed to prepare an electrolyte forming composition, which is coated on the light absorption layer to form a gel electrolyte.

The electrolyte forming composition may further include at least one selected from the group consisting of a viscosity-controlling polymer and a nitrogen-containing additive.

A second electrode is positioned on the gel electrolyte, and then, the first electrode is combined with the second electrode, thereby completing manufacturing of the dye sensitized solar cell.

The present invention will be described in further detail with reference to the following examples. These examples are for illustrative purposes only and are not intended to limit the scope of the present invention.

**Example 1: Preparation of electrolyte($PVP-I_2$ + $TiO_2$)**

A polyvinylpyrrolidone (PVP)-$I_2$ complex (in Formula 1, n=10 and m=80) was obtained from Aldrich Inc. and a mole ratio of a PVP repeating unit to $I_2$ was 10:1.

N-methyl-2-pyrrolidone (NMP) was directly used as an electrolytic solvent without being subjected to a separate purification process. The weight ratio of PVP-$I_2$ to $I_2$ (0.12M) was 1 (Ex1.1), 2.5 (Ex.1.2), 5 (Ex.1.3), and 7.5 (Ex.1.4): 1.

1-butyl-3-methyl imidazolium iodide (BMImI) 1.2 M, PVP-$I_2$, and 4-tertbutylpyridine (TBP) 0.5 M were dissolved in NMP.

$TiO_2$ was added to the resultant product and mixed by a centrifugal conditioning mixer (Thinky mixer) at a ratio of 2,000 rpm for 30 minutes to prepare an electrolyte. The amount of $TiO_2$ was about 5 weight % of the total weight of the electrolyte. An average particle diameter of $TiO_2$ was about 20 nm, and $TiO_2$ was sintered at a temperature of 500°C for 30 minutes before it was used in this experiment.

**Example 2: Preparation of electrolyte (PVP-$I_2$ + $TiO_2$ + polyethylene oxide (PEO))**

An electrolyte was prepared in the same manner as in Example 1, except that $TiO_2$ was used together with PEO (Mw = 300,000 g $mol^{-1}$).

An amount of the PEO was about 9 weight% based on the total weight of the electrolyte.

The amount of the PEO corresponds to 180 parts by weight based on 100 parts by weight of inorganic nanoparticles ($TiO_2$).

**Comparative Example 1: Preparation of electrolyte ($I_2$)**

NMP was directly used as a solvent to prepare an electrolyte without being subjected to a separate purification process. The amount of $I_2$ was fixed at 0.12 M. 1-butyl-3-methyl imidazolium iodide (BMImI) 1.2 M, $I_2$ and 4-tertbutylpyridine (TBP) 0.5 M were dissolved in NMP to prepare an electrolyte.

**Comparative Example 2: Preparation of electrolyte ($I_2$ + $TiO_2$)**

About 5 weight% of $TiO_2$ based on the total weight of the electrolyte was further added to the resultant product and mixed by a centrifugal conditioning mixer (Thinky mixer) at a ratio of 2,000 rpm for 30 minutes to prepare an electrolyte.

An average particle diameter of $TiO_2$ was about 20 nm, and $TiO_2$ was sintered at a temperature of 500 °C for 30 minutes before it was used in this experiment.

**Comparative Example 3: Preparation of electrolyte (PVP-$I_2$)**

An electrolyte was prepared in the same manner as in Comparative Example 1, except that PVP-$I_2$ was used instead of $I_2$.

**Evaluation Example: Manufacturing and evaluating of test cells**

$TiO_2$ paste (PST-18NR, JGC C&C, Japan) was coated to a thickness of 12 $\mu$m on a fluorine-containing tin oxide (FTO) substrate (thickness: 2.3 mm) by screen printing and calcinated at a temperature of 500 °C for 30 min. Then, scattering particles paste (400c, JGC C&C, Japan) was coated and calcinated in the same manner as described above to prepare a photo-cathode. A thickness of a coating layer of the scattering particles paste after the calcinating was about 4 $\mu$m.

The photo-cathode was immersed in a dye solution (0.2 mM N719/EtOH) and left for 24 hours. Separately, platinum (Pt) was scattered on FTO for 20 minutes to form an opposite electrode having holes.

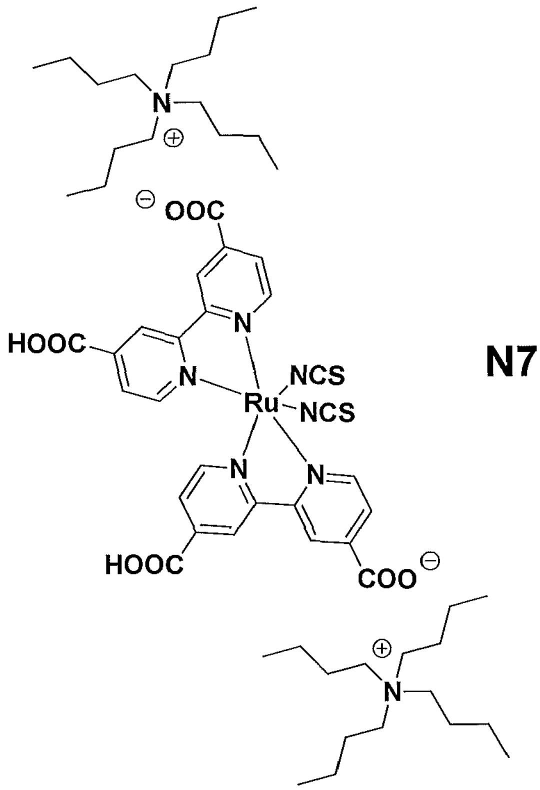

N719

A hot melt film (Suryln®, DuPont, 60 μm) was inserted between the photo-cathode and the opposite electrode having holes and then the photo-cathode and the opposite electrode were thermally attached to each other by hot pressing at a temperature of 130 °C for 15 seconds. The electrolytes prepared according to Examples 1 and 2 and Comparative Examples 1-3 were injected through the holes of the opposite electrode, thereby completing manufacturing of test cells.

The current-voltage test was performed on the test cells under reference evaluation conditions including AM1.5G and 100 mW $cm^{-2}$. Also, ionic conductivity and cell impedance of the test cells were measured using an impedance analyzer, and silver (Ag) corrosion evaluation was also performed using the test cells.

Open voltage, photocurrent density, energy conversion efficiency, and a fill factor of the test cells were measured and the results are shown in Table 1 below.

**(1) Open voltage ($V_{oc}$) and photocurrent density (Jsc)**

Open voltage and Photocurrent density were measured using Keithley SMU2400.

**(2)Energy conversion efficiency (R, %) and fill factor (%)**

Energy conversion efficiency was measured using a solar simulator of 1.5AM 100 mW/$cm^2$, composed of Xe lamp [300W, Oriel], an AM1.5 filter, and Keithley SMU2400), and the fill factor was calculated by giving the energy conversion efficiency to the following equation:

Equation

$$\text{Fill factor (\%)} = \frac{(J \times V)_{max}}{J_{sc} \times V_{oc}} \times 100$$

In the equation, J is a Y value of an energy conversion efficiency graph and V is an X value of the energy conversion efficiency graph, and $J_{sc}$ and $V_{oc}$ are intercept values of the respective axes.

Solar cells were manufactured using the electrolyte prepared according to Example 1 in which PVP-$I_2$ were used at various concentrations, and current-voltage characteristics of the solar cells were measured using a solar

simulator under reference measurement conditions, and the results are shown in Table 1 below. The photoelectric conversion characteristics shown in Table 1 were evaluated under conditions including AM1.5G and 100 mW $cm^{-2}$.

**Table 1**

| Electrolyte | | Iodine Content (mol) | Photoelectric conversion characteristics | | | | R/% |
|---|---|---|---|---|---|---|---|
| | | | Jsc/mA $cm^{-2}$ | Voc/V | FF/% | Eff/ % | |
| Example 1 | Ex.1.1 | 9.30 x $10^{-5}$ | 11.363 | 0.709 | 57.4 | 4.62 | -8.33 |
| | Ex.1.2 | 2.33 x $10^{-}$ | 11.583 | 0.675 | 60.7 | 4.74 | -5.95 |
| | Ex.1.3 | 4.65 x $10^{-4}$ | 11.815 | 0.639 | 61.5 | 4.64 | -7.94 |
| | Ex.1.4 | 6.98 x $10^{4}$ | 11.669 | 0.621 | 62.6 | 4.54 | -9.92 |

As shown in Table 1, the higher amount of PVP-$I_2$ results in the greater fill factor (FF). This is due to the fact that since ion transport limitation in an electrolyte is determined by $I_3^-$, the higher ionic concentration results in the higher conductivity.

However, the greater atnount of PVP-$I_2$ used leads to the higher dark current and the lower Voc. Thus, the electrolyte has highest efficiency at the iodine concentration of about 2.33 x $10^{-4}$mol (0.0465 mol/L).

Figures 2A and 2B show cell impedance test results of the electrolyte prepared according to Example 1.

From results measured under illumination conditions, it was confirmed that the greater amount of PV-P-$I_2$ leads to much smaller electrolyte diffusion resistance in a low fluency region.

It was also confirmed that Pt/electrolyte interfacial delivery resistance in a high frequency region is highly dependent on the iodine concentration. However, from impedance results measured in dark conditions, it was confirmed that when the amount of PVP-$I_2$ exceeds a set or predetermined level, a dark current is increased and thus cell impedance is largely reduced.

In order to identify ionic conductivity characteristics of the electrolytes, the 4-point probe impedance of the electrolytes was measured and the results are shown in Table 2 below:

**Table 2**

| Electrolyte | | Iodine content (mol) | Impedance (Ohm) | Conductivity (mS/cm) |
|---|---|---|---|---|
| Example 1 | Ex.1.1 | 9.30 x $10^{-5}$ | 8623.5 | 2.15 x $10^{-4}$ |
| | Ex.1.2 | 2.33 x $10^{-4}$ | 454.13 | 4.08 x $10^{-3}$ |
| | Ex. 1.3 | 4.65 x $10^{-4}$ | 485.23 | 3.82 x $10^{-3}$ |
| | Ex.1.4 | 6.98 x $10^{4}$ | 649.72 | 2.85 x $10^{-3}$ |

As shown in Table 2, as the amount of PVP-1, increases, ionic conductivity of the electrolyte is improved. However, when the amount of $I_2$ is greater than about 2.33 x $10^{-4}$ mol (0.0465 mol/L), the ionic conductivity is reduced. This is because the greater amount of the PVP polymer results in the higher viscosity of the electrolyte.

Solar cells were manufactured using the electrolytes prepared according to Example 1 and Comparative Examples 1-3 and current-voltage characteristics of the solar cells were measured using a solar simulator under reference measurement conditions, and the results are shown in Figure 3.

By referring to Figure 3, an optimal iodine concentration for the respective electrolytes is identified.

Referring to Figure 3, in order to perform an optical performance, the electrolyte of Example 1 requires a relatively low iodine concentration compared with the electrolytes of Comparative Examples 1 and 3. This is because the $TiO_2$ nanoparticles contribute to an increase in transport characteristics of the redox couple.

Impedance of solar cells manufactured according to Example 1, Comparative Example 1, and Comparative Example 3 were measured and the results are shown in Figure 4.

As illustrated in Figure 4, the electrolyte of Example 1 has smaller electrolyte diffusion resistance than those of Comparative Example 1 and Comparative Example 3. Referring to Figure 4, from the results obtained at 1 sun (i.e., open circuit voltage (OCV) in sunlight), it was confirmed that the higher iodine concentration leads to the lower electrolyte diffusion resistance in the low frequency region.

Photoelectric conversion characteristics of the solar cells manufactured using the electrolytes of Example 1, Comparative Examples 1 and 3 were evaluated and the results are shown in Table 3 below.

**Table 3**

| | Composition | Photoelectric conversion characteristics | | | | Efficiency R (%) |
|---|---|---|---|---|---|---|
| | | $J_{sc}$ (mAcm$^{-2}$) | $V_{oc}$ (V) | FF (%) | $E_{ff}$ (%) | |
| Example 1 | NMP/PVP-$I_2$ + $TiO_2$ | 10.743 | 0.742 | 70.1 | 5.59 | 10.91 |
| Comparative Example 1 | NMP/$I_2$ | 10.778 | 0.700 | 66.8 | 5.04 | 0.00 |
| Comparative Example 3 | NMP/PVP-$I_2$ | 10.165 | 0.721 | 65.9 | 4.83 | -4.17 |

Referring to Table 3, the solar cell manufactured using the electrolyte of Example 1 has higher efficiency than the solar cells of Comparative Example 1 and 3.

Impedance and conductivity characteristics of the electrolytes of Example 1 and Comparative Example 3 were evaluated and the results are shown in Table 4.

**Table 4**

| | Composition | Impedance (Ohm (Σ)) | Conductivity (mS/cm) |
|---|---|---|---|
| Example 1 | NMP/PVP-$I_2$ + $TiO_2$ | 1809.9 | $3.07 \times 10^{-3}$ |
| Comparative Example 3 | NMP/PVP-$I_2$ | 3962.3 | $1.40 \times 10^{-3}$ |

Referring to Table 4, it was confirmed when the $TiO_2$ nanoparticles are included in an electrotype, the ionic conductivity is doubled.

Also, in order to measure an Ag grid corrosion rate with respect to the electrolytes of Example 1 and Comparative Example 2, the electrolytes were injected to an Ag grid cell and a resistance change was evaluated at a temperature of 85 °C for 200 hours, and the results are shown in Figure 5.

Referring to Figure 5, the electrolyte of Example 1 has smaller resistance than the electrolyte of Comparative Example 2.

As described above, according to the one or more of the above embodiments of the present invention, an electrolyte for a dye sensitized solar cell has high ionic conductivity and a low metal electrode corrosion rate at a low iodine concentration.

A dye sensitized solar cell including the electrolyte has high photoelectron conversion efficiency.

It should be understood that the exemplary embodiments described therein should be considered in a descriptive sense only and not for purposes of limitation. Descriptions of features or aspects within each embodiment should typically be considered as available for other similar features or aspects in other embodiments.

While the present invention has been described in connection with certain exemplary embodiments thereof, it is to be understood that the invention is not limited to the disclosed embodiments, but, on the contrary, is intended to cover various modifications and equivalent arrangements included within the scope of the appended claims.

## Claims

**1.** A gel electrolyte for a dye sensitized solar cell, the gel electrolyte comprising:

a redox couple generated from a polymer-iodine complex and an iodide salt; inorganic nanoparticles; and
a high-viscosity organic solvent.

**2.** The gel electrolyte of claim 1, wherein the polymer of the polymer-iodine complex comprises at least one selected from the group consisting of polyvinylalcohol, polyvinylpyrrolidone, polyvinylpyridine, nylon, and polysaccharide.

**3.** The gel electrolyte of claim 1 or claim 2, wherein the polymer-iodine complex is represented by Formula1 below:

Formula 1

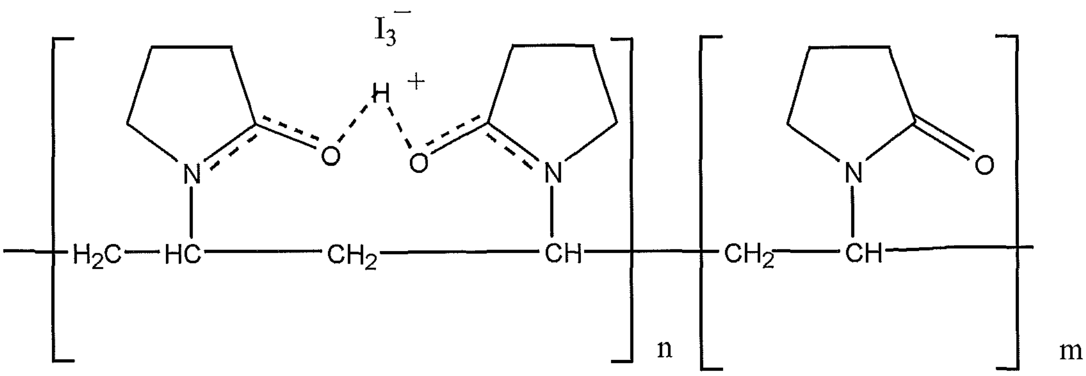

wherein n is a number from 5 to 1,000, and
m is a number from 5 to 10,000.

**4.** The gel electrolyte of any preceding claim, wherein the inorganic nanoparticles comprise at least one selected from the group consisting of titania, silica, and indium tin oxide.

**5.** The gel electrolyte of any preceding claim, wherein the high-viscosity organic solvent is an organic solvent having a boiling point of 120°C or higher.

**6.** The gel electrolyte of any preceding claim, wherein the high-viscosity organic solvent comprises at least one selected from the group consisting of 3-methoxypropionnitrile, N-methylpyrrolidone (NMP), 1-alkyl(R)-3-methylimidazolium tetracyanoborate, 1-alkyl(R)-3-methylimidazolium dicyanamide, and 1-alkyl R -3-methylimidazoliumbis trifluoromethylsulfonyl imide, wherein the alkyl (R) is a C1-C20 alkyl or a C1-C20 alkenyl.

**7.** The gel electrolyte of any preceding claim, wherein the gel electrolyte further comprises a polymer for controlling viscosity of the gel electrolyte.

**8.** The gel electrolyte of claim 7, wherein the polymer for controlling viscosity of the gel electrolyte is comprised in an amount between 20 and 200 parts by weight based on 100 parts by weight of the inorganic nanoparticles.

**9.** The gel electrolyte of claim 7 or claim 8, wherein the polymer for controlling viscosity of the gel electrolyte comprises at least one selected from the group consisting of an ethylene oxide-based polymer and a vinylidenefluoride-hexfluoropropylene copolymer.

**10.** The gel electrolyte of any preceding claim, wherein in the polymer-iodine complex, a mixed mole ratio of a repeating unit of the polymer to the iodine is in a range of 20:1 to 1:1.

**11.** The gel electrolyte of any preceding claim, wherein the redox couple generated from the polymer-iodine complex and the iodide salt comprises a cation of the polymer-iodine complex and an iodine ion ($I^-/I_3^-$).

**12.** The gel electrolyte of any preceding claim, wherein the redox couple is in an amount of between 40 and 400 parts by weight based on 100 parts by weight of the inorganic nanoparticles.

**13.** The gel electrolyte of any preceding claim, wherein the high-viscosity organic solvent is in an amount of between 1,000 and 1,600 parts by weight based on 100 parts by weight of the inorganic nanoparticles.

**14.** The gel electrolyte of any preceding claim, wherein the inorganic nanoparticles have an average particle diameter of between 5 and 200 nm.

**15.** The gel electrolyte of any preceding claim, wherein the iodide salt comprises at least one selected from the group consisting of lithium iodide (LiI), bromine iodide (LiBr), sodium iodide, potassium iodine, magnesium iodide, copper iodide, silicon iodide, manganese iodide, barium iodide, molybdenum iodide, calcium iodide, iron iodide, caesium iodide, zinc iodide, mercury iodide, ammonium iodide, methyl iodide, methylene iodide, ethyl iodide, ethylene iodide,

isopropyl iodide, isobutyl iodide, benzyl iodide, benzoyl iodide, allyl iodide, imidazolium iodide, pyridinium iodide, and pyrrolidinium iodide.

**16.** The gel electrolyte of any preceding claim, wherein the gel electrolyte further comprises at least one nitrogen-containing additive selected from the group consisting of 4-tertbutylpyridine, pyrazole, imidazole, 1,2,3-triazole, 1,2,4-triazole, tetrazole, pyridazine, pyrimidine, pyrazine, 1,3,5-triazine, 2-aminoquinoline, 3-aminoquinoline, 5-aminoquinoline, and 6-aminoquinoline.

**17.** The gel electrolyte of claim 16, wherein the nitrogen-containing additive is included in an amount of between 100 and 300 parts by weight based on 100 parts by weight of the inorganic nanoparticles.

**18.** A dye sensitized solar cell comprising:

a first electrode;
a light absorption layer formed on a surface of the first electrode;
a second electrode facing the first electrode on which the light absorption layer is formed; and
a gel electrolyte according to any of claims 1 to 17 interposed between the light absorption layer and the second electrode.

FIG. 1

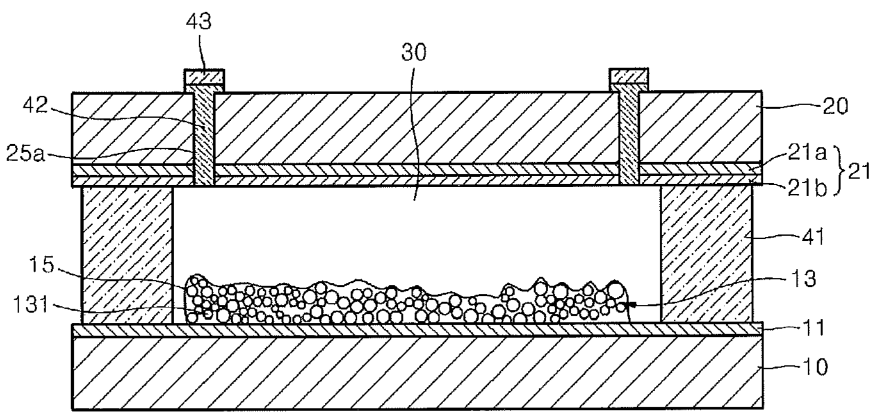

FIG. 2A

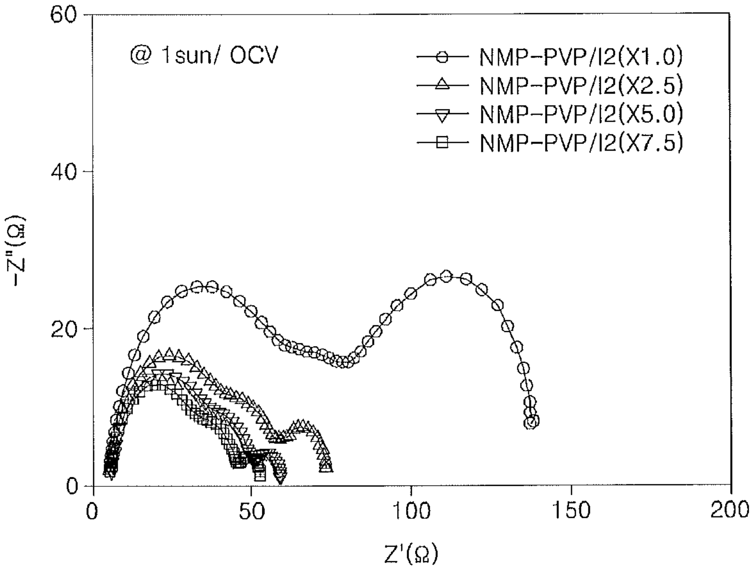
@ 1sun/ OCV
NMP-PVP/I2(X1.0)
NMP-PVP/I2(X2.5)
NMP-PVP/I2(X5.0)
NMP-PVP/I2(X7.5)
-Z"(Ω)
Z'(Ω)
0
20
40
60
0
50
100
150
200

FIG. 2B

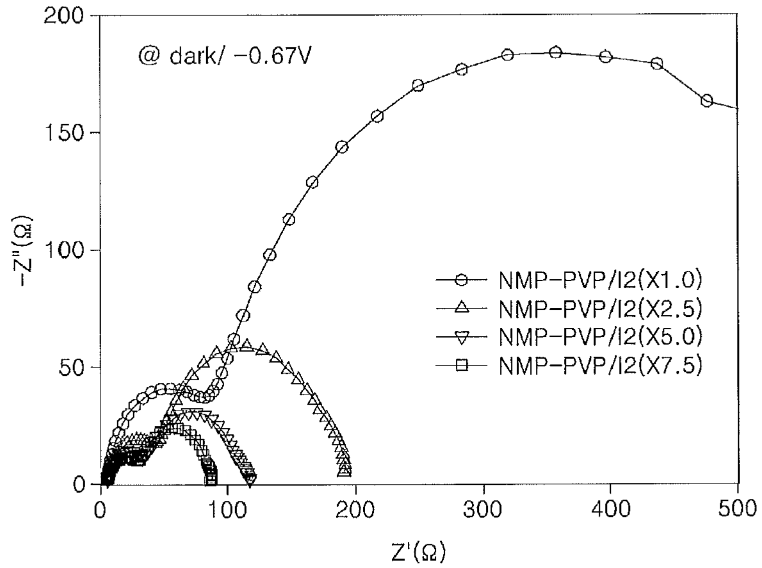
@ dark/ -0.67V
-Z"(Ω)
Z'(Ω)
NMP-PVP/I2(X1.0)
NMP-PVP/I2(X2.5)
NMP-PVP/I2(X5.0)
NMP-PVP/I2(X7.5)
0
50
100
150
200
0
100
200
300
400
500

FIG. 3

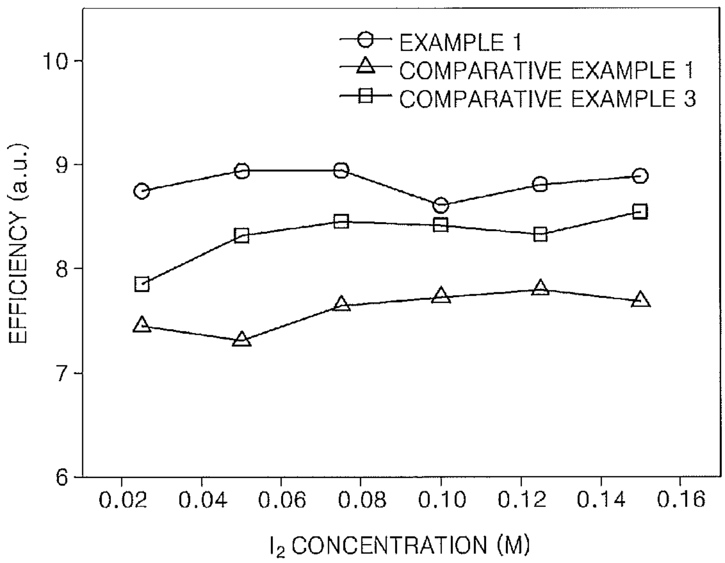
EXAMPLE 1
COMPARATIVE EXAMPLE 1
COMPARATIVE EXAMPLE 3
10
9
8
7
6
EFFICIENCY (a.u.)
0.02
0.04
0.06
0.08
0.10
0.12
0.14
0.16
I2 CONCENTRATION (M)

FIG. 4

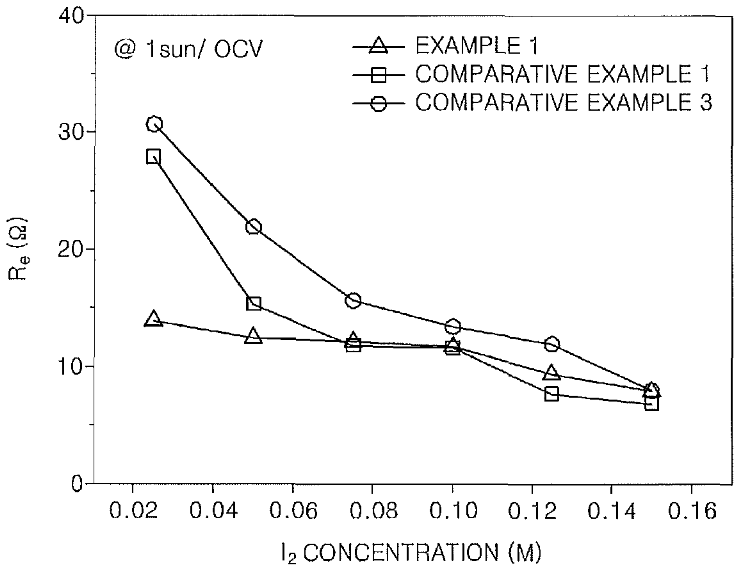
@ 1sun/ OCV
EXAMPLE 1
COMPARATIVE EXAMPLE 1
COMPARATIVE EXAMPLE 3
$R_e$ (Ω)
0
10
20
30
40
0.02
0.04
0.06
0.08
0.10
0.12
0.14
0.16
$I_2$ CONCENTRATION (M)

FIG. 5

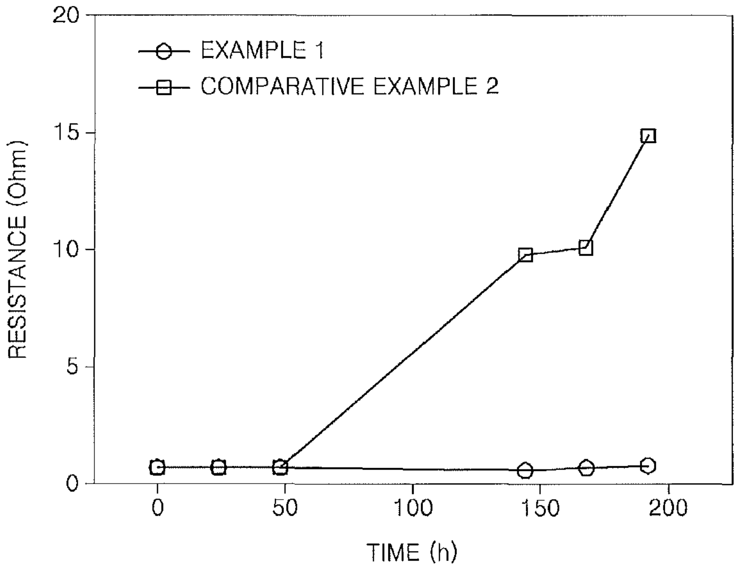
EXAMPLE 1
COMPARATIVE EXAMPLE 2
RESISTANCE (Ohm)
TIME (h)
0
5
10
15
20
0
50
100
150
200